# EUROPEAN PATENT APPLICATION

(11) **EP 4 834 524 A1**
(43) Date of publication of application: **04.11.2026**
(21) Application number: 24909454.1
(22) Date of filing: 08.04.2024
(51) Int. Cl.: B24B 37/10, B24B 37/30

(54) **SYSTEM FOR CHEMICAL MECHANICAL POLISHING AND PLANARIZATION**

(30) Priority: 26.12.2023 CN 202311824272; 05.03.2024 CN 202410246767
(71) Applicant: Hangzhou Sizone Electronic Technology Inc., Hangzhou Zhejiang 311300 (CN)
(72) Inventor: GU, Haiyang, Hangzhou, Zhejiang 311300 (CN); DENG, Yaomin, Hangzhou, Zhejiang 311300 (CN); ZHENG, Shengliang, Hangzhou, Zhejiang 311300 (CN)
(74) Representative: Becker, Eberhard
(86) International application number: PCT/CN2024/086517
(87) International publication number: WO 2025/138485

(57) **Abstract**

Disclosed is a system for chemical mechanical polishing and planarization, said system at least comprising a polishing head. The polishing head comprises: a polishing head body; a rigid disc, on a lower surface of which a plurality of air holes are formed and inside of which a third air cavity in communication with the air holes is formed; an elastic unit, which is at least partially of an annular structure, the elastic unit being separately connected to the polishing head body and the rigid disc, and the polishing head body, the elastic unit, and the rigid disc forming a second air cavity; and a retaining ring, which is located below the polishing head body. When the third air cavity is in a negative pressure state, the lower surface of the rigid disc can make contact with and suction onto a wafer substrate, the pressure in the second air cavity can be controlled so as to drive the elastic unit to flexibly move, so as to assist the rigid disc and the wafer substrate to float, achieving chemical mechanical polishing of the wafer substrate. According to the present invention, rigid driving in the rigid disc solves the problem of breakage or changes in elastic modulus due to a flexible film being dragged under severe polishing conditions when the flexible film drives the wafer substrate to be polished, thus prolonging the service life of flexible parts.

## Description

### TECHNICAL FIELD

The present invention belongs to the technical field of fabrication of semiconductor integrated circuit chips, and particularly relates to a chemical mechanical polishing and planarization system.

### BACKGROUND

The manufacturing process for wafer substrates and semiconductor devices includes processes such as polishing and surface planarization. Generally, the technique such as mechanical polishing, chemical mechanical polishing, or planarization is employed. A pressure is applied to the back side of a wafer by means of a wafer carrier (a polishing head), parameters such as the pressure, the rotational speed of the polishing head, the rotational speed of a platen, and the flow rate of a polishing slurry are controlled, and the front surface or film surface of a wafer substrate is polished or planarized on a polishing pad. Compared with mechanical polishing, chemical mechanical polishing and planarization, by adjusting the formulation of the polishing slurry, induce a chemical reaction on the surface of the wafer, which can achieve higher polishing or planarization efficiency, as well as better polishing or planarization effects, including higher flatness, less defects, and so on. There are mainly two approaches for applying a pressure to the wafer substrate by the polishing head. One of the two approaches is to apply a pressure by means of an air chamber of a flexible membrane. In short, the flexible membrane in direct contact with the wafer substrate may have a single chamber or multiple chambers, and by controlling the pressure in the chamber of the flexible membrane, the pressure distribution applied to the wafer substrate is adjusted, thereby achieving regional thickness control of the wafer substrate; the other approach is to apply a pressure by means of a rigid disc, which is in direct contact with the wafer substrate. The rigid disc is driven by a rigid guide rod, which directly applies a vertical downward force to the rigid disc, which in turn relatively uniformly acts on the wafer substrate. By comparing these two approaches, the approach of applying a pressure by means of the air chamber of the flexible membrane has the advantage that the regional pressure of the wafer substrate may be regulated, allowing for modification of local regions, but it has a relatively small effect on the overall thickness variation of the wafer substrate; the approach using the rigid disc may, to a certain extent, optimize the overall thickness variation of the wafer substrate, but it lacks the ability to modify local regions.

Based on chemical mechanical polishing and planarization described above, for conductive substrates or conductive film materials, electrochemical reactions may be conducted on the wafer substrate or the film surface by means of an electrochemical mechanical polishing and planarization system on the basis of the conductive properties of the wafer substrate or the film on the wafer surface, and the rate of surface chemical reactions is increased by precise control of a circuit system, thereby improving mechanical polishing and planarization efficiency. In common embodiments, the polishing head is typically insulated, and the insulated polishing head does not participate in the circuit architecture. In some embodiments, rigid-contact vacuum conductive chucks may be used. The circuit architectures of existing electrochemical mechanical polishing and planarization equipment are extremely complex. In addition to this, electrode wear and rigid contact also increase the risks such as metal contamination and scratches of wafer substrates during the process. Furthermore, one of the current paths in existing electrochemical mechanical planarization equipment is established by means of electrodes on the edge of the platen. As a result, the current magnitude and distribution from the center to the edge of the platen are nonuniform. Moreover, the wafer is adsorbed and secured by a vacuum conductive chuck, and due to the movement of the movable platen, the relative movement distance between the wafer and the platen is small, which may result in nonuniform electrochemical reactions on the wafer; and since the conductive chuck is typically a rigid disc loaded by a spindle, and the rigid conductive disc lacks in-plane pressure control, and thus cannot be used to control in-plane uniformity on the wafer surface. In addition, there is also an electropolishing head that loads electrodes around the outer circumference of the wafer and forms planar conduction across the polished surface of the wafer by means of multiple contact points. However, such an electrode design is complex, and the contact with the outer circumference of the wafer causes wear. A flexible chamber pressurization-based polishing head and a rigid disc-based polishing head (where the wafer substrate is attached to the bottom surface of a rigid disc by wax sealing/film lamination) are respectively used for the two types of chemical-mechanical polishing and planarization mentioned above. In the two aforementioned approaches, both a flexible rubber airbag and the hard-plate wax sealing/film-lamination of the rigid disc are electrically insulated or weakly conductive, so the conduction of ampere-level currents from the wafer cannot be achieved by means of the polishing heads. Therefore, the main challenges limiting the application of conductive polishing heads are, on the one hand, the need to perform multiple tasks such as wafer substrate loading, unloading, and pressurization, and, on the other hand, the requirement for high electrical conductivity.

Based on the above background art, conventional polishing heads for chemical mechanical polishing and planarization cannot simultaneously achieve optimization of the overall thickness variation and the function of local region modification. Therefore, the technical approaches of the two polishing heads mentioned above may be combined to develop a novel polishing head that achieves regional modification by incorporating flexible chamber control by using a rigid disc for overall thickness adjustment while adding flexible chamber control for regional modification. Furthermore, with regard to the electrochemical polishing and planarization technique, by making the rigid disc of the polishing head conductive, the application of the novel polishing head to electrochemical polishing and planarization is achieved.

### SUMMARY

To overcome the defects in the prior art, the present invention provides a chemical mechanical polishing and planarization system. A rigid disc may implement loading and unloading of a wafer substrate and adsorb or not adsorb the wafer substrate by controlling the pressure in a third air chamber, and an elastic unit and a second air chamber work together to control the rigid disc to drive the wafer substrate to move, such that the service life of a polishing head is prolonged while effective chemical mechanical polishing and planarization of the wafer substrate are guaranteed.

The technical solution adopted by the present invention to solve the technical problems is as follows: a chemical mechanical polishing and planarization system includes at least a polishing head. The polishing head includes:
a polishing head body;
a rigid disc, at least a portion of a lower surface of the rigid disc being coplanar, a plurality of air holes being formed in the coplanar portion of the lower surface, and a third air chamber, communicating with the air holes, being formed in the rigid disc;
an elastic unit, at least a portion of the elastic unit being a ring structure, the elastic unit being connected to the polishing head body and the rigid disc, and the polishing head body, the elastic unit and the rigid disc defining a second air chamber;
a retaining ring, the retaining ring being located below the polishing head body and being a ring part in contact with a polishing pad, and the rigid disc moving in a region defined by the retaining ring;
   when the third air chamber is in a negative pressure state, the lower surface of the rigid disc comes into contact with and adsorbs a wafer substrate; a pressure in the second air chamber is controllable to drive the elastic unit to move flexibly so as to assist the rigid disc and the wafer substrate in floating to implement chemical mechanical polishing of the wafer substrate.

Further, the rigid disc is made from a conductive material or conductive treatment is performed on a surface of the rigid disc to implement electrochemical mechanical polishing and planarization of the wafer substrate.

Further, a circuit for the electrochemical mechanical polishing and planarization of the wafer substrate is connected to the rigid disc via the elastic unit; or, the circuit is connected to the rigid disc directly from electrodes; or, the circuit is connected to the rigid disc from the polishing head body.

Further, the lower surface of the rigid disc is horizontal; or, a horizontal portion of the lower surface of the rigid disc forms a thickened region or a thinned region to form a height difference from nanoscale to microscale.

Further, the elastic unit is made from an elastic material, one side of the ring structure of the elastic unit is connected to an outer ring of the rigid disc, and the other side of the ring structure of the elastic unit is connected between the polishing head body and the retaining ring.

Further, a guide cylinder extends out from a central axis of the polishing head body towards the rigid disc, a guide sleeve is formed on a side, facing away from the wafer substrate, of the rigid disc, the guide sleeve is concentric and coaxial with the rigid disc, the guide cylinder extends into the guide sleeve or the guide sleeve extends into the guide cylinder, and a radial movement clearance exists between the guide cylinder and the guide sleeve.

Further, one of the guide cylinder and the guide sleeve is provided with at least one drive pin, the other one of the guide cylinder and the guide sleeve is provided with at least one drive groove, the drive pin extends into the drive groove, and a circumferential movement clearance exists between the drive pin and the drive groove.

Further, the number of the drive pins is equal to that of the drive grooves.

Further, the rigid disc is provided with a guide rod, and the guide rod vertically extends out upwards from a center of the polishing head body.

Further, a guide tube extends through an inside of the guide rod, and the guide tube communicates with the third air chamber.

Further, a guide cylinder extends out from a central axis of the polishing head body towards the rigid disc, one of the guide cylinder and the guide rod is provided with at least one drive pin, the other one of the guide cylinder and the guide rod is provided with at least one drive groove, the drive pin extends into the guide groove, and a circumferential movement clearance exists between the drive pin and the drive groove.

Further, a flexible fabric is attached to the lower surface of the rigid disc, the flexible fabric includes air holes, and the air holes match at least some of the air holes of the rigid disc in position.

Further, the flexible fabric is a conductive flexible fabric.

Further, the flexible fabric is a non-conductive material. A pore of the flexible fabric is filled with electrolyte, to make the wafer substrate and the polishing head body be electrically connected.

Further, the flexible fabric is a sponge structure, or, the flexible fabric is a foamed polymer.

Further, the polishing head body includes at least one fourth air chamber located above the rigid disc, and an air pressure in the fourth air chamber is variable to perform pressurization or depressurization on a specific region of the rigid disc.

Further, the fourth air chamber is located above a central region of the rigid disc; or, the fourth air chamber is a ring-shaped or disc-shaped air chamber, which is located above and concentric with the rigid disc.

Further, a first air chamber is formed in the polishing head body and used for controlling a vertical stroke of a portion of the polishing head body.

Further, a diameter of the air holes is 0.1-3 mm, and a total area of the air holes accounts for 0.1-5% of an area of the lower surface of the rigid disc.

Further, a waterproof and breathable layer is arranged on the lower surface of the rigid disc.

Further, an edge limiter is arranged on the rigid disc, and the edge limiter abuts against a cut edge of the wafer substrate and an inner wall of the retaining ring, or abuts against the cut edge of the wafer substrate.

Further, the retaining ring is provided with grooves for a polishing slurry to flow in or out, and the edge limiter is provided with guide grooves communicating with the grooves; the edge limiter is made from an insulating material.

The present invention has the following beneficial effects: 1) a relatively uniform overall downward pressure may be implemented by means of the rigid disc, thereby improving the overall thickness variation; 2) the elastic unit is used for local pressurization, thereby assisting the rigid disc in modification of local regions; 3) in a case where a flexible membrane is used as a drive component to drive a wafer substrate for polishing, the balance state of the flexible membrane will fluctuate in regions such as grooves in the polishing pad, thereby affecting the polishing velocity and exerting a negative impact on polishing efficiency; whereas, the stability of rigid drive in the rigid disc is higher, thereby effectively solving the abovementioned problems and achieving better process stability; 4) the rigid drive in the rigid disc solves the problem that when a flexible membrane drives the wafer substrate for polishing, the flexible membrane is pulled to be ruptured or the elastic modulus changes under a harsh polishing condition, thereby prolonging the service life of a flexible member in the polishing head; 5) the wafer substrate is adsorbed by means of the negative pressure of the rigid disc, such that when the polishing head leaves the polishing pad, the situation where the wafer substrate scrapes against the polishing pad due to the retraction of the flexible membrane is avoided, thus ensuring that the wafer substrate is quickly and effectively separated from the polishing pad, and guaranteeing that the polishing process proceeds smoothly; 6) the chemical mechanical polishing and planarization system not only may be used for common chemical mechanical polishing, but also may be used for electrochemical polishing and planarization by conductive treatment on the rigid disc, thereby having high adaptability; 7) the circuit conduction between the polishing head and the wafer substrate is implemented by means of the conductive rigid disc to perform electrochemical mechanical polishing and planarization, such that long-term stability of electrochemical reactions is guaranteed, and the process stability of electrochemical mechanical polishing and planarization is higher; 8) the edge limiter configured for wafer substrates in specific shapes may effectively prevent edge oxidization of the rigid disc or a conductive flexible membrane on the rigid disc, thereby prolonging the service life of the rigid disc or the conductive flexible membrane; 9) the rigid disc works together with the flexible chambers to perform overall pressurization and local pressurization on the wafer substrate, such that modification of local regions is achieved while the overall thickness variation of the wafer substrate is optimized.

### BRIEF DESCRIPTION OF THE DRAWINGS

FIG. 1 is a front view according to Embodiment one of the present invention.
FIG. 2 is a first schematic structural stereogram according to Embodiment one of the present invention.
FIG. 3 is a second schematic structural stereogram according to Embodiment one of the present invention.
FIG. 4 is a bottom view according to Embodiment one of the present invention.
FIG. 5 is a sectional view according to Embodiment one of the present invention.
FIG. 6 is an enlarged view of part A in FIG. 5.
FIG. 7 is a schematic structural stereogram of a rigid disc and an elastic unit according to Embodiment one of the present invention.
FIG. 8 is a cutaway structural view of the rigid disc according to Embodiment one of the present invention.
FIG. 9 is a partial sectional view of the cooperation between a polishing head body and a rigid disc according to Embodiment two of the present invention.
FIG. 10 is a sectional view according to Embodiment three of the present invention.
FIG. 11 is a sectional view according to Embodiment three of the present invention, where a retaining ring is not shown.
FIG. 12 is a schematic partial structural stereogram according to Embodiment three of the present invention.
FIG. 13 is a first sectional view according to Embodiment four of the present invention.
FIG. 14 is a second sectional view according to Embodiment four of the present invention.
FIG. 15 is a sectional view according to Embodiment five of the present invention.
FIG. 16 is a first schematic partial structural stereogram according to Embodiment five of the present invention.
FIG. 17 is a second schematic partial structural stereogram according to Embodiment five of the present invention.
FIG. 18 is a sectional view according to Embodiment six of the present invention.
FIG. 19 is a first schematic structural diagram of the cooperation between a rigid disc, a wafer substrate and an edge limiter according to Embodiment seven of the present invention.
FIG. 20 is a second schematic structural diagram of the cooperation between the rigid disc, the wafer substrate and the edge limiter according to Embodiment seven of the present invention.
FIG. 21 is a third schematic structural diagram of the cooperation between the rigid disc, the wafer substrate and the edge limiter according to Embodiment seven of the present invention.
FIG. 22 is a fourth schematic structural diagram of the cooperation between the rigid disc, the wafer substrate and the edge limiter according to Embodiment seven of the present invention.
FIG. 23 is a bottom view of a conductive fabric according to Embodiment eight of the present invention.

Wherein, 1- polishing head body, 11- guide cylinder, 12- radial movement clearance, 13- first air chamber, 2- rigid disc, 21- air hole, 22- third air chamber, 221- guide tube, 23- guide sleeve, 24- guide rod, 26- fourth air chamber, 27- gas passage, 28- conductive fabric, 281- air hole in conductive fabric, 3- elastic unit, 4- second air chamber, 41- gas input passage, 5-retaining ring, 51- groove, 61- drive pin, 62- drive groove, 7- edge limiter, 71- guide groove, 8-wafer substrate, 81- cut edge of wafer substrate.

### DETAILED DESCRIPTION OF THE EMBODIMENTS

To allow those skilled in the art to gain a better understanding of the technical solutions of the present invention, the technical solutions in the embodiments of the present invention are clearly and completely described below in conjunction with accompanying drawings of the embodiments of the present invention. Obviously, the embodiments described below are merely illustrative ones rather than all possible ones of the present invention. All other embodiments obtained by those ordinarily skilled in the art on the basis of the following ones without creative labor should also fall within the protection scope of the present invention.

### Embodiment one

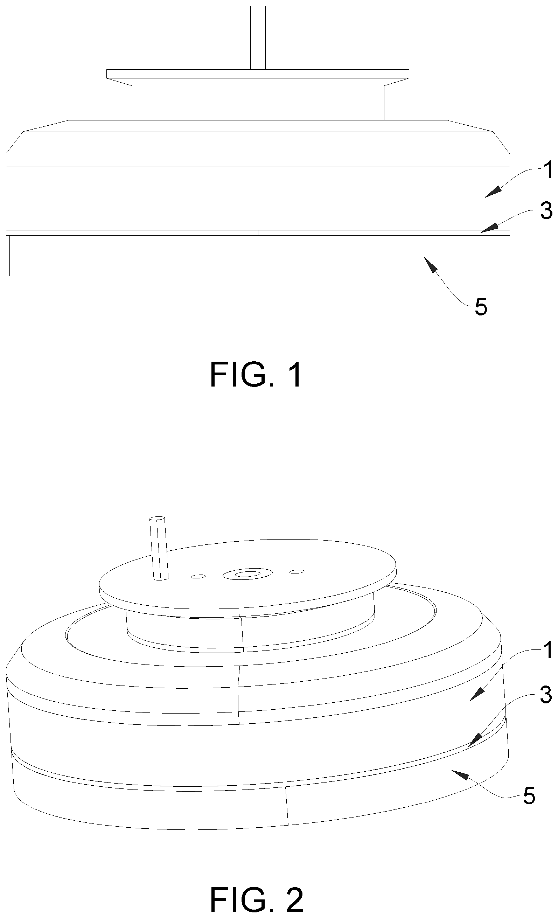

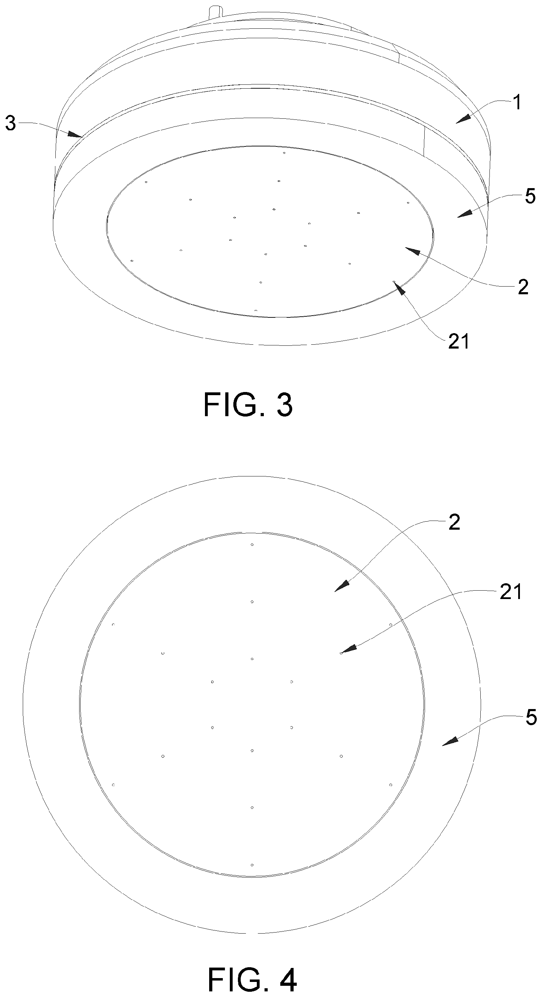

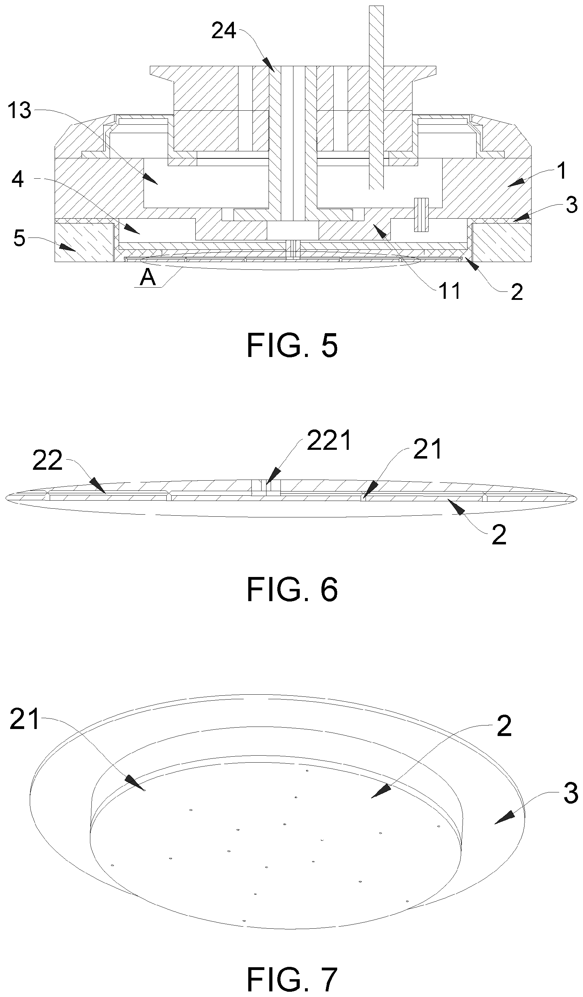

As shown in FIGS. 1-7, a chemical mechanical polishing and planarization system includes at least a polishing head. The polishing head includes a polishing head body 1, a rigid disc 2, an elastic unit 3 connected to the polishing head body 1 and the rigid disc 2, and a retaining ring 5 located below the polishing head body 1. A first air chamber 13 is formed in the polishing head body 1 and used for controlling ascending, descending and a vertical stroke of a portion of the polishing head body 1 to drive the rigid disc 2 and a wafer substrate to ascend and descend.

The rigid disc 2 is a conductive disc made from a rigid material, such as a metal, a conductive material or other rigid conductive materials. The metal may be specifically aluminum, titanium or stainless steel, the other conductive materials may be conductive ceramic, graphite, and the like, and all these materials are conductive materials. Alternatively, the surface of the rigid disc 2 is treated with a conductive material. In this way, the rigid disc 2, together with the wafer substrate, a platen and a power supply, may form a conduction path necessary for electrochemical mechanical polishing and planarization, power is conducted to the rigid disc 2 and then conducted to the wafer substrate for surface modification, and then mechanical polishing is performed.

A circuit for electrochemical mechanical polishing and planarization of the wafer substrate may be connected to the rigid disc 2 directly from electrodes; or, the circuit may be connected to the rigid disc 2 from the elastic unit 3; or, the circuit may be connected to the rigid disc 2 from the polishing head body 1. The present invention has no specific limitation in this aspect.

At least a portion of a lower surface of the rigid disc 2 is coplanar. In this embodiment, the lower surface of the rigid disc 2 is horizontal. Of course, in other embodiments, a specific region of the horizontal portion of the rigid disc 2 may be thickened or thinned on the basis of the thickness and topography of the wafer substrate to form a thickened region or a thinned region, such that a height difference from nanoscale to microscale is formed between different regions. In other embodiments, insulating treatment and chamfering treatment may be performed on a side surface of the rigid disc 2, where the insulating treatment includes, but is not limited to, hard anodizing, surface coating, and the like.

Of course, in other embodiments, the rigid disc 2 may also be made from a non-conductive material, and in this case, it is used for chemical mechanical polishing of the wafer substrate.

An upper surface of the rigid disc 2 is airtight. At least a portion of the lower surface of the rigid disc 2 is horizontal, and a plurality of air holes 21 are formed in the horizontal portion of the lower surface. A third air chamber 22, communicating with the air holes 21, is formed in the rigid disc 2. A sealed connection is necessary for the third air chamber 22 to prevent contamination of the polishing head caused by leakage of a polishing slurry. The other functional components may be connected in any manners as long as the internal environment of the polishing head is not affected, such as air tube connection, screw and sealing ring-based connection of a main body, chamber design of a flexible membrane and other sealing designs, which may be implemented by existing techniques and will not be detailed here. The diameter of the air holes 21 is 0.1-3 mm, and the total area of all the air holes 21 accounts for 0.1-5% of the area of the lower surface of the rigid disc 2. When a negative pressure is formed in the third air chamber 22, the lower surface of the rigid disc 2, to be precise the horizontal portion of the lower surface, may directly come into contact and adsorb the wafer substrate.

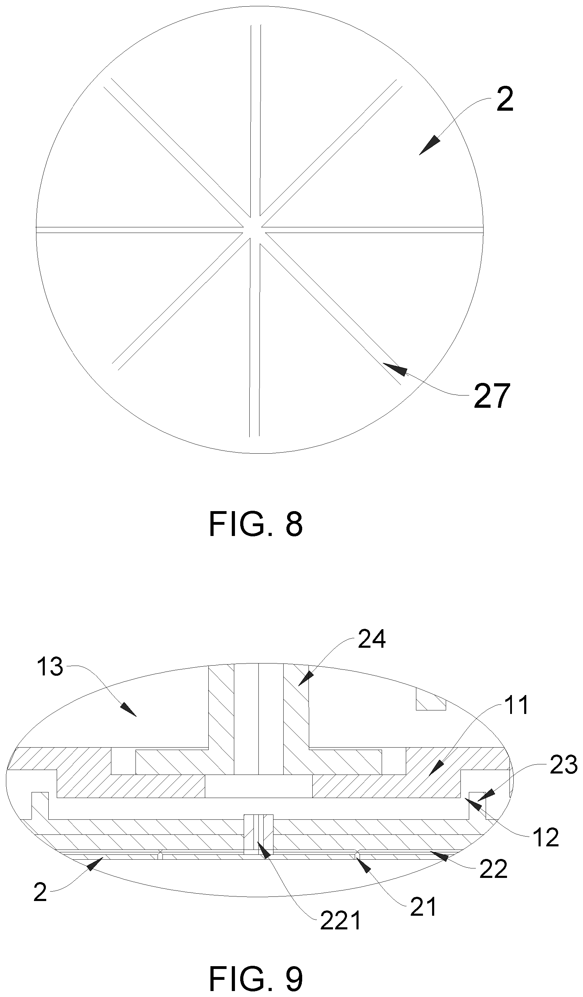

In this embodiment, all the air holes 21 communicate with each other. As shown in FIG. 8, air passages 27, which radially intersect and communicate with each other, are formed in the rigid disc 2. The air passages 27 communicate with the third air chamber 22, and the air holes 21 are correspondingly formed in a region where the air passages 27 are located, such that negative pressures formed by all the air holes 21 are relatively uniform.

One of the logics for determining whether the wafer substrate is loaded onto the polishing head body 1 is to perform a pressure hold test after the third air chamber 22 is vacuumized, to detect the vacuum condition of the third air chamber 22. If the negative pressure is held, it is determined that the wafer substrate is loaded onto the polishing head body 1; otherwise, it is determined that the wafer substrate is not loaded onto the polishing head body 1.

The retaining ring 5 may be a ring part in contact with a polishing pad, and the rigid disc 2 moves in a region defined by the retaining ring 5.

The elastic unit 3 is made from an elastic material and is approximately a ring structure. One side of it is connected to an outer ring of the rigid disc 2, and the other side of it is fixedly connected between the polishing head body 1 and the retaining ring 5. The elastic unit 3 defines a second air chamber 4, together with the polishing head body 1 and the rigid disc 2. The pressure in the second air chamber 4 is controllable, such that the elastic unit 3 may be driven to move flexibly by regulating the pressure in the second air chamber 4, so as to assist the rigid disc 2 and the wafer substrate in floating to implement electrochemical mechanical polishing and planarization of the wafer substrate. Herein, the floating of the rigid disc 2 and the wafer substrate refers to improving motions of the rigid disc 2 and the wafer substrate by means of the elastic unit 3 under the precondition of mechanical drive of the polishing head 1 and the rigid disc 2, where the motions include vertical floating and radial floating. The method for controlling the pressure in the second air chamber 4 may be implemented by existing techniques, and will not be detailed here.

Sealing and pressure control of the second air chamber 4 may be implemented by existing techniques, and will not be detailed here.

In the present invention, a conventional structure that uses a rigid support disc and a flexible membrane to adsorb a wafer substrate is changed, the rigid disc 2 directly adsorbs the wafer substrate, and on the basis of an existing drive structure, and the elastic unit 3 assists the rigid disc 2 and the wafer substrate in rotation, ascending and descending, swinging and other motions in the retaining ring 5 by changing the pressure in the second air chamber 4, that is, the rigid disc 2 and the wafer substrate float vertically and radially to implement electrochemical mechanical polishing and planarization of the wafer substrate. The rigid disc 2 has good electrical conductivity and thermal conductivity, and during electrochemical mechanical polishing and planarization, the polishing slurry and the heat increase involved in the process will not exert a negative impact on the rigid disc 2, and poor electrical conductivity, corrosion and poor stability of the flexible membrane in the traditional structure are avoided.

### Embodiment two

In Embodiment one, the motions of the rigid disc 2 and the wafer substrate are implemented by an existing mechanical drive structure, and the elastic unit 3 assists the rigid disc 2 and the wafer substrate in floating. In this embodiment, a new mechanical drive structure is used.

As shown in FIG. 9, in this embodiment, a guide cylinder 11 extends out from the central axis of the polishing head body 1 towards the rigid disc 2, a guide sleeve 23 is formed in a side, facing away from the wafer substrate, of the rigid disc 2, the guide sleeve 23 is concentric and coaxial with the rigid disc 2, the guide cylinder 11 vertically extends into the guide sleeve 23, and a radial movement clearance 12 exists between them. Herein, the radial movement clearance 12 refers to that the outer diameter of the guide cylinder 11 is less than the inner diameter of the guide sleeve 23, such that after the guide cylinder 11 is inserted into the guide sleeve 23, the guide cylinder 11 may move to drive the guide sleeve 23 while the elastic unit 3 drives the rigid disc 2 to move flexibly, that is, the polishing head body 1 may be in mechanical limit fit with the rigid disc 2, thereby making the motion of the rigid disc 2 highly controllable.

Of course, in other embodiments, the guide sleeve 23 may vertically extend into the guide cylinder 11, and a radial movement clearance 12 exists between them.

### Embodiment three

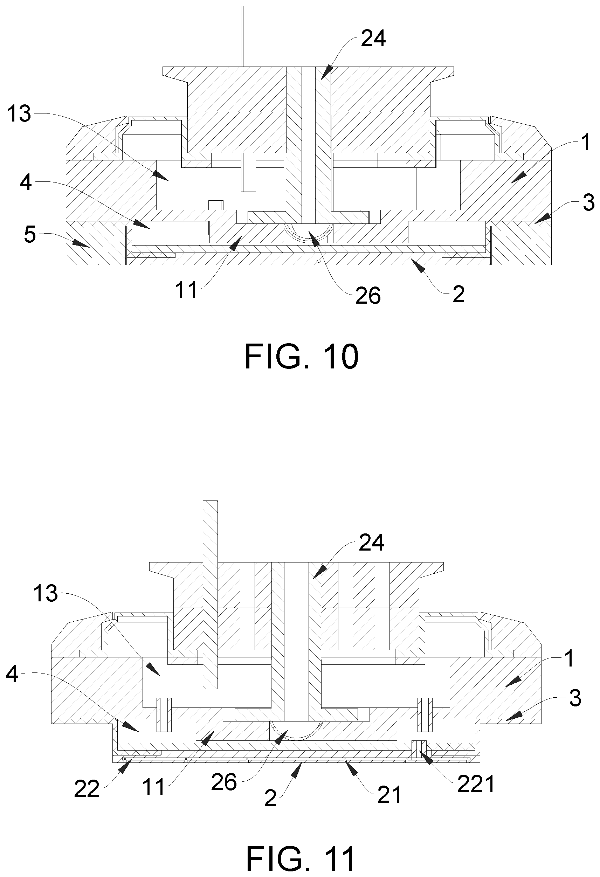

As shown in FIGS. 10-12, the polishing head body 1 includes a fourth air chamber 26, the fourth air chamber 26 is located above the rigid disc 2, and the air pressure in the fourth air chamber 26 is variable to pressurize or depressurize the rigid disc 2.

Specifically, the fourth air chamber 26 may be located above a central region of the rigid disc 2, and in this case, it is a semispherical chamber. Alternatively, the fourth air chamber 26 is a ring-shaped or disc-shaped air chamber, which is located above and concentric with the rigid disc 2.

In this embodiment, the fourth air chamber 26 is a circular or ring-shaped chamber located above the rigid disc 2. When inflated to expand, the rigid disc presses the rigid disc 2 downward, and the downward pressure may be flexibly adjusted.

Pressure control of the fourth air chamber 26 may be implemented by existing techniques, and will not be detailed here.

Of course, a plurality of fourth air chambers may be provided to perform directional pressurization or depressurization on the rigid disc 2 so as to implement directional pressurization or depressurization of a specific region of the wafer substrate. One function of the fourth chambers is to achieve regional pressure control of the wafer substrate, and the other function of the fourth air chambers to further improve the stability of the polishing head by multi-chamber pressurization.

### Embodiment four

On the basis of Embodiment two, one of the guide cylinder 11 and the guide sleeve 23 is provided with at least one drive pin 61, and the other one is provided with at least one drive groove 62. The guide pin 61 horizontally extends into the guide groove 62, and a circumferential movement clearance exists between them.

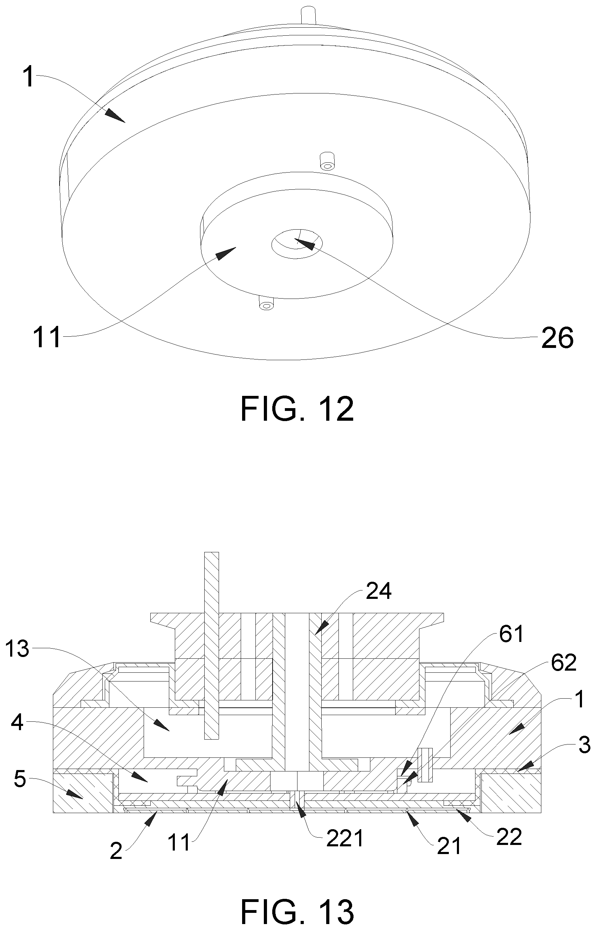

Specifically, as shown in FIGS. 13-14, the drive pin 61 is formed on the outer circumference of the guide cylinder 11. In this embodiment, a plurality of drive pins 61 are uniformly arranged along the outer circumference of the guide cylinder 11 at intervals. Of course, in other embodiments, one drive pin 61 may be arranged symmetrically in the radial direction. The present invention has no specific limitation in this aspect.

One or more drive grooves 62 are formed in the guide sleeve 23. The number of it is the same as that of the drive pins 61, and also are uniformly arranged at intervals in the circumferential direction of the guide sleeve 23.

When the polishing head body 1 and the rigid disc 2 are assembled, the drive pin 61 is inserted into the drive groove 62, and the width of the drive pin 61 is less than that of the drive groove 62, such that a circumferential movement clearance exists between them, that is, the drive pin 61 is able to swing circumferentially in the drive groove 62. In this way, while the elastic unit 3 drives the rigid disc 2 to move flexibly and the polishing head body 1 comes into mechanical limit fit with the rigid disc 2, the polishing head body 1 may mechanically drive the rigid disc 2 by means of the driven pin 61 and the drive groove 62, such that the rigid disc 2 may move more effectively to drive the wafer substrate for electrochemical mechanical polishing and planarization.

Rigid drive is achieved by means of the drive pin 61 and the drive groove 62, and the elastic unit 3 assists the rigid disc 2 in overcoming slight disturbance, such that the movement controllability of the rigid disc 2 and the wafer substrate is higher, the process stability is higher, and accordingly, the controllability of the electrochemical mechanical polishing and planarization process or the chemical mechanical polishing process is high.

### Embodiment five

In this embodiment, the rigid disc 2 is provided with a guide rod 24, the guide rod 24 vertically extends out upwards from the center of the polishing head body 1, and a radial movement clearance exists between the guide rod 24 and the polishing head body 1.

A guide cylinder 11 is formed at the central axis of the polishing head body 1 and located on a side facing the rigid disc 2, one of the guide cylinder 11 and the guide rod 24 is provided with at least one drive pin 61, the other one is provided with at least one drive groove 62, the drive pin 61 extends into the drive groove 62, and a circumferential movement clearance exists between them.

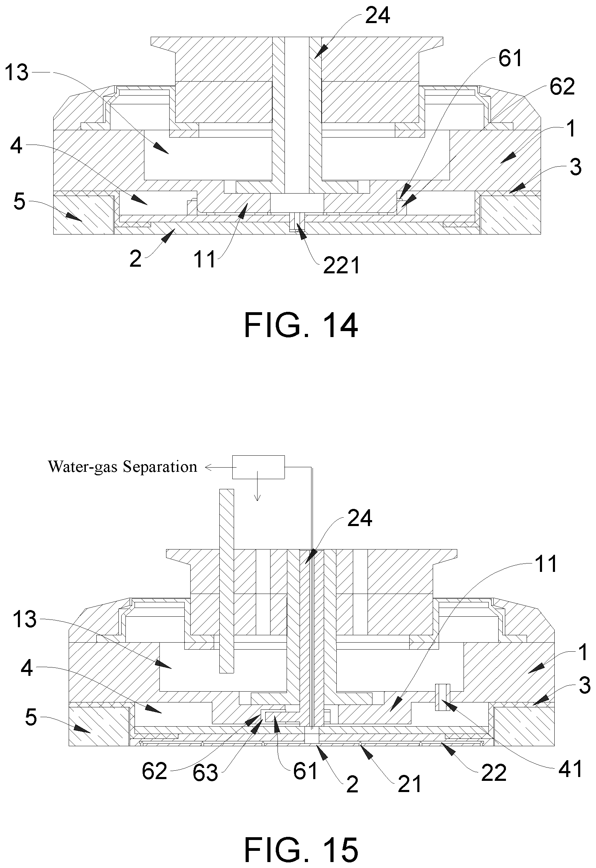

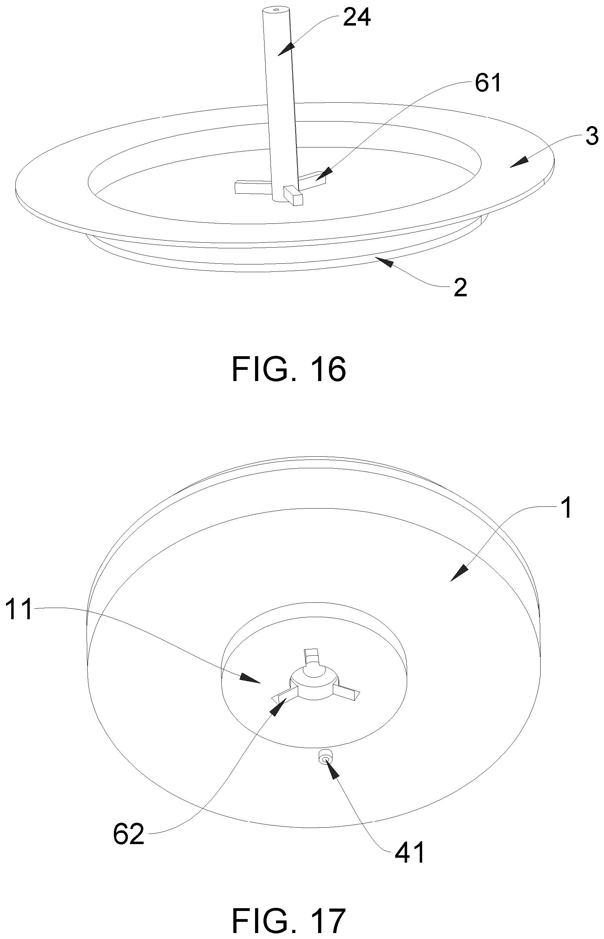

Specifically, as shown in FIGS. 15-17, three drive pins 61 are uniformly arranged on an outer wall of the guide rod 24 at intervals in the circumferential direction, an inner ring of the guide cylinder 11 is hollowed out to form three drive grooves 62, and the width of the drive grooves 62 is greater than that of the drive pins 61, such that when the drive pins 61 are inserted into the drive grooves 62, a circumferential movement clearance exits between them, that is, the drive pins 61 are able to swing circumferentially in the drive grooves 62.

In this way, while the elastic unit 3 drives the rigid disc 2 to move flexibly and the polishing head body 1 comes into mechanical limit fit with the rigid disc 2, the polishing head body 1 may mechanically drive the rigid disc 2 by means of the driven pin 61 and the drive groove 62, such that the rigid disc 2 may move more effectively to drive the wafer substrate for electrochemical mechanical polishing and planarization.

Moreover, the guide rod 24 may be a hollow structure, a guide tube 221 extends through the inside of it, and the guide tube 221 communicates with the third air chamber 22. Because the polishing slurry will be sucked into the guide tube 221 synchronously when the wafer substrate is adsorbed under the negative pressure in the third air chamber 22, the guide tube 221 communicating with the third air chamber 22 is washed every time polishing is completed, and the back side of the wafer substrate is washed at the same time. The guide tube 221 is connected to an air path control system by means of the polishing head body 1 via a conductive slip ring, and implements water-gas separation.

### Embodiment six

In Embodiment one to Embodiment five, neither the gas input form of the second air chamber 4 nor whether the second air chamber 4 is divided into a plurality of sub-air chambers is defined.

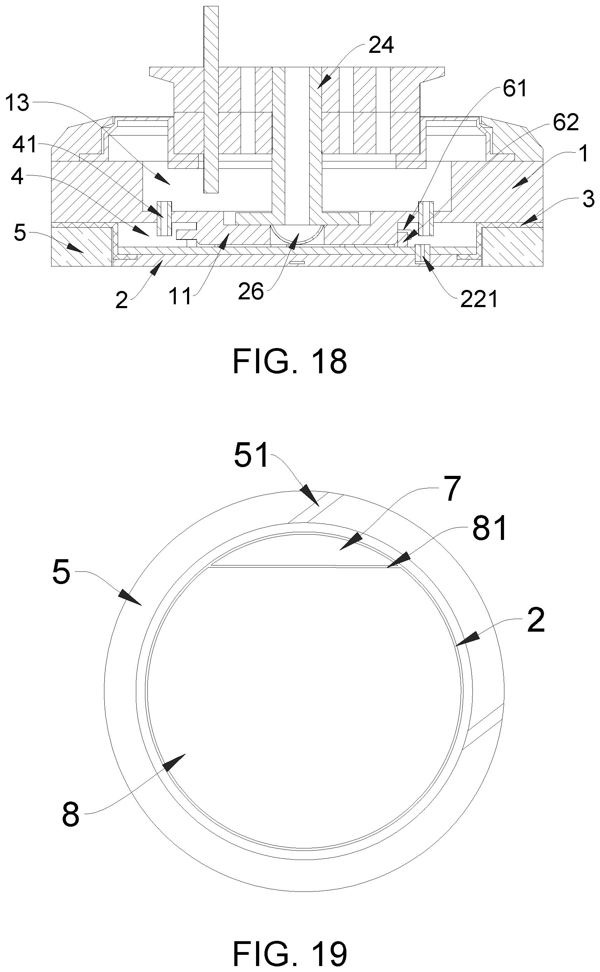

As shown in FIG. 18, different from Embodiment five where the second air chamber 4 is provided with only one gas input passage 41, in this embodiment, the second gas chamber 4 is provided with two gas input passages 41, and they are symmetrically distributed in the radial direction, such that gas is input to the second gas chamber 4 more uniformly, the controllability is higher, and the rigid disc 2 is driven more flexibly and effectively.

### Embodiment seven

For some conductive wafer substrates 8 in an irregular shape, such as a 6-inch silicon carbide wafer substrate 8 with a cut edge 81, due to the absence of a conductive wafer substrate 8 medium at the position of the cut edge 81, the rigid disc 2 is still partially exposed to the outside after adsorbing the wafer substrate 8, and if the rigid disc 2 is directly energized for oxidization, the service life of the rigid disc 2 will be affected. In addition, due to the rotation and swinging of the wafer substrate 8 with the polishing head body 1, the rotation of the platen and other motions, the cut edge 81 of the wafer substrate 8 and the rigid disc 2 will slide relatively, causing a circle of electrical oxidation at the edge. Therefore, a limiting design is necessary for the special-shaped conductive wafer substrate 8 to restrict the rotation of the wafer substrate 8 inside the polishing head body 1.

As shown in FIG. 19, an edge limiter 7 is additionally arranged on the surface of the rigid disc 2, the edge limiter 7 is made from an insulating material and may be attached to or inlaid in the rigid disc 2, that is, the edge limiter 7 may abut against the cut edge 81 of the wafer substrate and the inner wall of the retaining ring 5, the edge limiter 7 needs to be flush with the wafer substrate 8 when loaded or slightly lower than the lower surface of the wafer substrate 8, and a height difference is ≤ 0.3 mm.

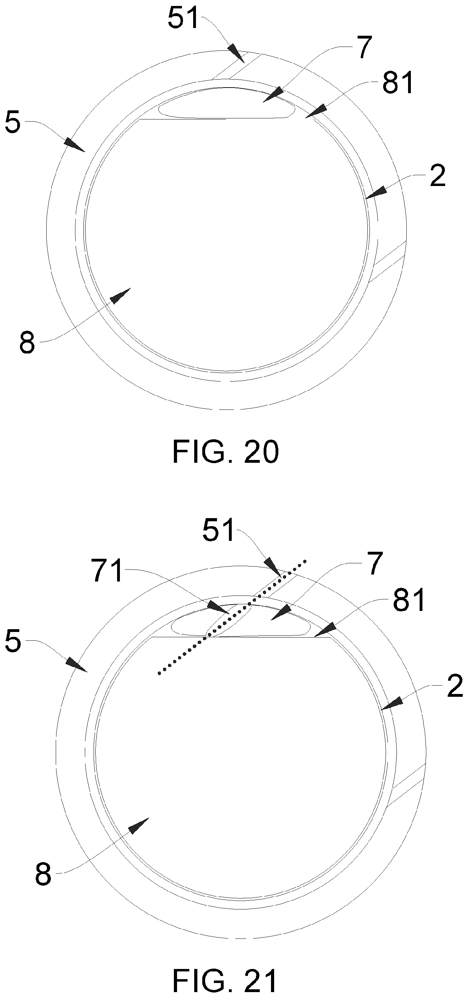

To prevent the edge limiter 7 from colliding with the vertex of the cut edge 81, the overall length of the edge limiter 7 may be decreased, and the edge of it may be chamfered, as shown in FIG. 20.

To ensure that the polishing slurry enters the polishing head body 1 more smoothly via grooves 51 of the retaining ring 5, guide grooves 71 may be formed in the edge limiter 7, the angle of the guide grooves 71 is kept the same as that of extended lines of the grooves 51 of the retaining ring 5, and the width of the guide grooves 71 is the same as that of the grooves 51 of the retaining ring 5, as shown in FIG. 21.

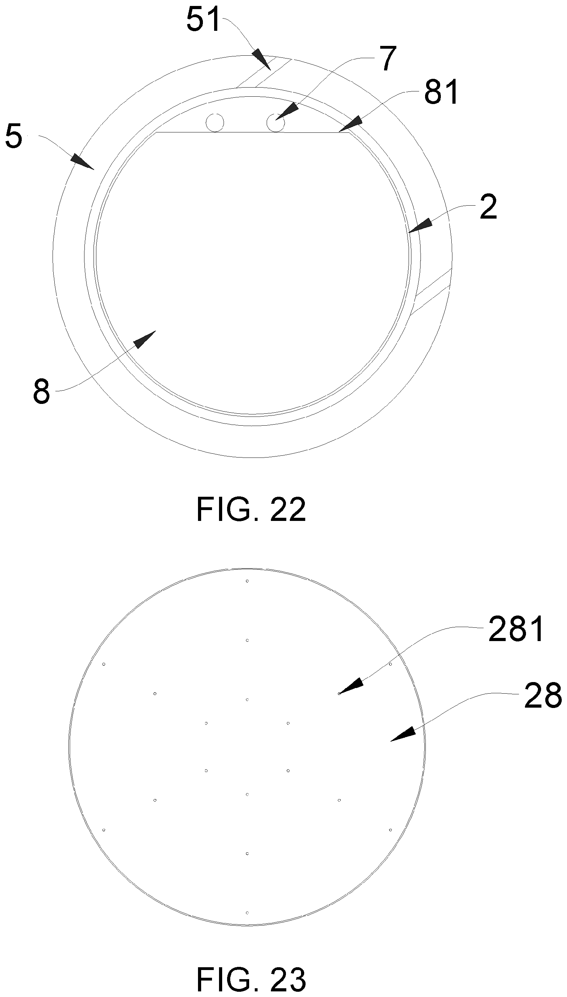

As shown in FIG. 22, the edge limiter 7 may be simplified into a multi-point limiting structure, the number N of points of the limiting structure is ≥ 2, and in this case, the edge limiter 7 abuts against the cut edge 81 of the wafer substrate.

### Embodiment eight

In this embodiment, a flexible conductive fabric 28 is attached to the lower surface of the rigid disc 2, and the electrical resistivity of it is <10⁻³mΩ·cm. As shown in FIG. 23, the flexible conductive fabric 28 includes air holes 281, and the air holes 281 match at least some of the air holes 21 of the rigid disc 2 in position, such that the air path is smoother during pressurization or vacuumizing of the air chamber 3, and a wafer may be better adsorbed during vacuum treatment of the air chamber 3.

Of course, the flexible conductive fabric 28 may also be merely a flexible fabric, and does not need to have the electrical conduction function. That is, the flexible fabric is a non-conductive material. At this time, a pore of the flexible fabric is filled with electrolyte, to make the wafer substrate and the polishing head body 1 be electrically connected. That is, in the chemical polishing process, the flexible fabric is filled with electrolyte, to make the electrolyte be connected to the back side of the wafer substrate and a wafer support surface of the polishing head body 1, to form a loop.

Specifically, some pores may be filled with electrolyte, while some pores may only be used to adsorb the wafer substrate; a single pore may also simultaneously function as adsorbing for the wafer substrate and the electrical conduction loop at the same time, that is, the electrolyte flows through the inner wall of the pore to realize the function that the electrolyte is connected to the back side of the wafer substrate and a wafer support surface of the polishing head body 1 to form the loop.

Of course, the flexible fabric can be woven fabric, the flexible fabric can also be the foamed polymer, or a sponge structure with interconnecting from top to bottom. The flexible fabric only needs to be nonconductive and possess a certain degree of flexibility, to ensure it would not abrade the back side of the wafer substrate. There are no specific limitations.

The other structures in this embodiment are the same as those in any one of Embodiments one to five, and will not be detailed here.

### Embodiment nine

In this embodiment, a waterproof and breathable layer is attached to the lower surface of the rigid disc 2. The waterproof and breathable layer allows gas to pass through during under vacuumizing and pressurization conditions, and does not adsorb moisture or allow moisture to pass through, thereby ensuring that no chemical or moisture will be sucked in during the negative pressure operation on the wafer substrate. The waterproof and breathable layer may be attached to the entire lower surface, or may be attached merely to the positions of the air holes 21 in the lower surface of the rigid disc 2. In the case where the waterproof and breathable layer is attached to the entire lower surface, the waterproof and breathable layer needs to be conductive. In the case where the waterproof and breathable layer is attached merely to the positions of the air holes 21, the edges of both sides of the waterproof and breathable layer need to be bonded with a conductive adhesive.

The other structures in this embodiment are the same as those in any one of Embodiments one to five and will not be detailed here.

The above specific embodiments are used for explaining the present invention rather than limiting the present invention. Any modifications and transformations made to the present invention based on the spirit of the present invention and within the protection scope of the claims should fall within the protection scope of the present invention.

## Claims

1. A chemical mechanical polishing and planarization system, **characterized in that**, comprising at least a polishing head, wherein the polishing head comprises:
a polishing head body (1);
a rigid disc (2), at least a portion of a lower surface of it being coplanar, a plurality of air holes (21) being formed on a coplanar portion of the lower surface, and a third air chamber (22), communicating with the plurality of air holes (21), being formed in the rigid disc (2);
an elastic unit (3), at least a portion of it being a ring structure, being connected to the polishing head body (1) and the rigid disc (2), and the polishing head body (1), the elastic unit (3) and the rigid disc (2) defining a second air chamber (4);
a retaining ring (5), being located below the polishing head body (1) and being a ring part in contact with a polishing pad, and the rigid disc (2) moving in a region defined by the retaining ring (5);
wherein, when the third air chamber (22) is in a negative pressure state, the lower surface of the rigid disc (2) comes into contact with and adsorbs a wafer substrate; a pressure in the second air chamber (4) is controllable to drive the elastic unit (3) to move flexibly so as to assist the rigid disc (2) and the wafer substrate in floating to implement chemical mechanical polishing of the wafer substrate.

2. The chemical mechanical polishing and planarization system according to claim 1, **characterized in that**: the rigid disc (2) is made from a conductive material or conductive treatment is performed on a surface of it to implement electrochemical mechanical polishing and planarization of the wafer substrate.

3. The chemical mechanical polishing and planarization system according to claim 2, **characterized in that**: a circuit for the electrochemical mechanical polishing and planarization of the wafer substrate is connected to the rigid disc (2) from the elastic unit (3); or, the circuit is connected to the rigid disc (2) directly from electrodes; or, the circuit is connected to the rigid disc (2) from the polishing head body (1).

4. The chemical mechanical polishing and planarization system according to claim 1, **characterized in that**: the lower surface of the rigid disc (2) is horizontal; or, a horizontal portion of the lower surface of the rigid disc (2) forms a thickened region or a thinned region to form a height difference from nanoscale to microscale.

5. The chemical mechanical polishing and planarization system according to claim 1, **characterized in that**: the elastic unit (3) is made from an elastic material, one side of the ring structure of it is connected to an outer ring of the rigid disc (2), and the other side of it is connected between the polishing head body (1) and the retaining ring (5).

6. The chemical mechanical polishing and planarization system according to claim 1, 2, 3 or 5, **characterized in that**: a guide cylinder (11) extends out from a central axis of the polishing head body (1) towards the rigid disc (2), a guide sleeve (23) is formed on a side, facing away from the wafer substrate, of the rigid disc (2), the guide sleeve (23) is concentric and coaxial with the rigid disc (2), the guide cylinder (11) extends into the guide sleeve (23) or the guide sleeve (23) extends into the guide cylinder (11), and a radial movement clearance (12) exists between them.

7. The chemical mechanical polishing and planarization system according to claim 6, **characterized in that**: one of the guide cylinder (11) and the guide sleeve (23) is provided with at least one drive pin (61), the other one is provided with at least one drive groove (62), the at least one drive pin (61) extends into the at least one drive groove (62), and a circumferential movement clearance exists between them.

8. The chemical mechanical polishing and planarization system according to claim 7, **characterized in that**: the number of the at least one drive pin (61) is equal to that of the at least one drive groove (62).

9. The chemical mechanical polishing and planarization system according to claim 1, 2, 3 or 5, **characterized in that**: the rigid disc (2) is provided with a guide rod (24), and the guide rod (24) vertically extends out upwards from a center of the polishing head body (1).

10. The chemical mechanical polishing and planarization system according to claim 9, **characterized in that**: a guide tube (221) extends through an inside of the guide rod (24), and the guide tube (221) communicates with the third air chamber (22).

11. The chemical mechanical polishing and planarization system according to claim 9, **characterized in that**: a guide cylinder (11) extends out from a central axis of the polishing head body (1) towards the rigid disc (2), one of the guide cylinder (11) and the guide rod (24) is provided with at least one drive pin (61), the other one is provided with at least one drive groove (62), the at least one drive pin (61) extends into the at least one guide groove (62), and a circumferential movement clearance exists between them.

12. The chemical mechanical polishing and planarization system according to claim 1, 2, 3 or 5, **characterized in that**: a flexible fabric is attached to the lower surface of the rigid disc (2), the flexible fabric comprises air holes, and the air holes match at least some of the plurality of air holes of the rigid disc in position.

13. The chemical mechanical polishing and planarization system according to claim 12, **characterized in that**: the flexible fabric is a conductive flexible fabric.

14. The chemical mechanical polishing and planarization system according to claim 12, **characterized in that**: the flexible fabric is a non-conductive material, a pore of the flexible fabric is filled with electrolyte, to make the wafer substrate and the polishing head body (1) be electrically connected.

15. The chemical mechanical polishing and planarization system according to claim 12, **characterized in that**: the flexible fabric is a sponge structure, or, the flexible fabric is a foamed polymer.

16. The chemical mechanical polishing and planarization system according to claim 1, **characterized in that**: the polishing head body (1) comprises at least one fourth air chamber (26) located above the rigid disc (2), and an air pressure in the at least one fourth air chamber (26) is variable to perform pressurization or depressurization on a specific region of the rigid disc (2).

17. The chemical mechanical polishing and planarization system according to claim 16, **characterized in that**: the at least one fourth air chamber (26) is located above a central region of the rigid disc (2); or, the at least one fourth air chamber (26) is a ring-shaped or disc-shaped air chamber, which is located above and concentric with the rigid disc (2).

18. The chemical mechanical polishing and planarization system according to claim 1, 2, 3 or 5, **characterized in that**: a first air chamber (13) is formed in the polishing head body (1) and used for controlling a vertical stroke of a portion of the polishing head body (1).

19. The chemical mechanical polishing and planarization system according to claim 1, 2, 3 or 5, **characterized in that**: a diameter of the plurality of air holes (21) is 0.1-3 mm, and a total area of it accounts for 0.1-5% of an area of the lower surface of the rigid disc (2).

20. The chemical mechanical polishing and planarization system according to claim 1, 2, 3 or 5, **characterized in that**: a waterproof and breathable layer is arranged on the lower surface of the rigid disc (2).

21. The chemical mechanical polishing and planarization system according to claim 1, 2, 3 or 5, **characterized in that**: an edge limiter (7) is arranged on the rigid disc (2), and it abuts against a cut edge (81) of the wafer substrate and an inner wall of the retaining ring (5), or abuts against the cut edge (81) of the wafer substrate.

22. The chemical mechanical polishing and planarization system according to claim 21, **characterized in that**: the retaining ring (5) is provided with grooves (51) for a polishing slurry to flow in or out, and the edge limiter (7) is provided with guide grooves (71) communicating with the grooves (51); the edge limiter (7) is made from an insulating material.
